# EUROPÄISCHE PATENTSCHRIFT

(11) **EP 0 742 486 B1**
(45) Veröffentlichungstag und Bekanntmachung des Hinweises auf die Patenterteilung: **08.12.1999**
(21) Anmeldenummer: 96106585.1
(22) Anmeldetag: 26.04.1996
(51) Int. Cl.: G03F 3/10

(54) **Trägermaterial zur Herstellung von Farb-Prüfdrucken im Analog-Proofsystem**
Support for forming colour proofs in the analogic proof system
Support pour former des épreuves-couleur dans le système analogique de tirage d'épreuves

(30) Priorität: 10.05.1995 DE 19517040
(43) Veröffentlichungstag der Anmeldung: 13.11.1996
(73) Patentinhaber: Felix Schoeller jr Foto- und Spezialpapiere GmbH & Co. KG, 49086 Osnabrück (DE)
(72) Erfinder: Becker, Dieter, Dr., 49124 Georgsmarienhütte (DE); Graumann, Jürgen, 49090 Osnabrück (DE)
(74) Vertreter: Cohausz & Florack

(56) Entgegenhaltungen:
- EP-A- 0 590 322
- EP-A- 0 622 681

## Beschreibung

Die vorliegende Erfindung betrifft ein Trägermaterial zur Herstellung von Farb-Prüfdrucken im sogenannten Analog-Proofsystem.

An der Herstellung von Druckerzeugnissen ist eine Kette von Produktionsstufen beteiligt. Eine wichtige Stufe stellt der Andruck dar, der bei vorschriftsmäßiger Anfertigung bereits vor Druckbeginn ein genaues Abbild des erreichbaren Druckergebnisses liefert. Mit dem Andruck ist die Möglichkeit gegeben, noch vor Druckbeginn gezielt Änderungswünsche einzubringen, die in die Reproduktion einfließen können und somit zum gewünschten Endprodukt führen.

Um die Andruckanfertigung kostengünstiger zu gestalten, wurden Andruckersatzsysteme (Proofsysteme) entwickelt, die in der Lage sein müssen, den späteren Fortdruck zu simulieren.

Die verschiedenen verfügbaren analog arbeitenden Proofsysteme unterscheiden sich in erster Linie im chemischen System und damit verbunden im Verarbeitungsprozeß. Die zur Bilderzeugung einen naßchemischen Entwicklungsschritt benötigenden Diazo-Verfahren und die trocken arbeitenden Fotopolymersysteme haben sich weitgehend durchgesetzt.

Zu den trocken arbeitenden Proofsystemen gehört beispielsweise das "Cromalin"-Verfahren. Hierbei handelt es sich um ein Laminatverfahren mit Trockentonerauftrag. Eine auf einem Trägermaterial aufgebrachte klebrige Monomerschicht polymerisiert bei der Beschichtung durch einen Farbauszugsfilm an den vom Licht getroffenen Stellen und verliert dort ihre Klebrigkeit. An den verbleibenden klebrigen Stellen lagert sich dann der Trockentoner an. Dieser Vorgang wiederholt sich mit den restlichen Farben, bis das komplette Bild entstanden ist.

Als Trägermaterial zur Herstellung von Prüfdrucken werden üblicherweise polyethylenbeschichtete oder gestrichene Papiere wie beispielsweise das sogenannte "Kromkote"-Papier eingesetzt.

Der visuelle Bildeindruck wird wesentlich stärker vom sogenannten Tonwertzuwachs beeinflußt, als vom Farbort einer Farbe. Der Tonwertzuwachs ergibt sich aus dem Zuwachs der Rasterpunktgröße.

Im Druck ist der Punktzuwachs in erster Linie geometrischer Natur. Beim Druckvorgang wird die Druckfarbe vom Druckträger über ein Gummituch auf das Papier übertragen. Bei diesem Vorgang wird der Rasterpunkt in der Regel mehr oder weniger breit gequetscht.

Bei den Laminat-Prüfdrucken beruht die Tonwertzunahme auf einem optischen Effekt (Lichtfang). Der Effekt entsteht durch Streuung des einfallenden Lichtes im Bedruckstoff in einer Randzone rund um den Rasterpunkt.

Bei visueller Gegenüberstellung liegen die im Mitteltonbereich gemessenen Tonwertzunahmen im Proof-Bild deutlich höher als beim Druck. Das Bild erscheint satter als der Wirklichkeit entspricht.

Beim Simulieren der Druckergebnisse mit Hilfe eines Proof-Druckes ist es daher wichtig, den gesamten Punktzuwachs des Proof-Bildes dem gesamten Punktzuwachs der Druckvorlage anzugleichen, d.h. den optischen Punktzuwachs zu verkleinern.

In der US-PS 4 579 810 kann die Reduzierung der Punkt zunahme durch einen bestimmten Glanz des Trägermaterials erreicht werden. Nachteilig ist jedoch, daß die darauf aufzubringenden und die Punktgröße ebenfalls beeinflussenden fotopolymerisierbaren Schichten sehr dünn aufgetragen werden müssen, was schwierig zu realisieren ist.

In der EP 0 243 932 Al wird der Punktzuwachs durch Zugabe von Di(meth)acrylat in die auf ein beschichtetes Papier aufgebrachten fotopolymerisierbaren Schichten reduziert.

Ein weiterer Versuch den optischen Punktzuwachs zu reduzieren, ist in der EP 0 305 599 Al beschrieben. Um das Ziel zu erreichen, wird ein mit einer TiO₂-Dispersion beschichtetes Basispapier eingesetzt. Nachteilig ist jedoch, daß das Auftragsgewicht der auf den Träger aufzubringenden lichtempfindlichen Schichten sehr gering sein muß.

Die EP 0 590 332 A2 beschreibt ein Bildempfangsmaterial für die thermische Farbstoffdiffusionsübertragung mit einem Träger und einer Mikrokugeln enthaltenden Zwischenschicht. Die Zwischenschicht enthält ferner ein filmbildendes Bindemittel und hat die Aufgabe, einen möglichst guten und gleichmäßigen Kontakt des Thermokopfs des Thermodruckers mit dem Bildempfangsmaterial zu bewirken. Die EP 0 622 681 A1 beschreibt ein color proof Material mit einem Träger, der ein Weißpigment, hohle Mikrokugeln und ein hydrophiles Bindemittel (Gelatine) aufweist.

Es ist daher Aufgabe der vorliegenden Erfindung, ein Trägermaterial zur Herstellung von Farb-Prüfdrucken im Analog-Proofsystem vorzuschlagen, mit dessen Hilfe eine Verringerung des optischen Punktzuwachses erreicht werden kann.

Die Aufgabe wird durch ein Trägermaterial gelöst, welches aus einem Träger und einer darauf angeordneten Schicht besteht, die ein hydrophobes Bindemittel oder ein Bindemittelgemisch und ein hohle Mikrokugeln enthaltendes Pigmentgemisch enthält.

Als Träger eignet sich ein Rohpapier, gestrichenes Papier, harzbeschichtetes Papier oder eine Kunststoffolie. Besonders geeignet ist aber ein ein- oder beidseitig mit Polyethylen beschichtetes Basispapier mit einem Flächengewicht von 80 bis 250 g/m². Das Basispapier kann mit Polyethylen niedriger Dichte (LDPE) oder mit Polyethylen hoher Dichte (HDPE) sowie mit einer Mischung beider Polyethylentypen beschichtet werden. In einer besonderen Ausgestaltung der Erfindung enthält die vorderseitige und die rückseitige Polyethylenbeschichtung 10 bis 70 Gew.% HDPE. Die Auftragsmenge der Polyethylenbeschichtung liegt im Bereich von 15 bis 50 g/m².

Die erfindungsgemäße Schicht kann hydrophobe Bindemittel enthalten wie Acrylsäureester, Polyvinylacetat, Vinylchlorid/Vinylacetat-Copolymer, Polystyrol, Polyurethan, Polyvinylchlorid, Polyvinylidenchlorid, Styrol/Butadien-Copolymer, styrolisierter Acrylsäureester oder ein Gemisch aus diesen Bindemitteln.

Besonders bevorzugt sind aus Vinylchlorid/Vinylacetat-Copolymer oder aus styrolisiertem Acrylsäureester bestehende Bindemittel.

Der Bindemittelgehalt in der Schicht beträgt 15 bis 95 Gew.%, vorzugsweise 20 bis 80 Gew.%, ganz besonders bevorzugt 20 bis 50 Gew.%, bezogen auf die trockene Schicht.

Ein weiterer Bestandteil der erfindungsgemäßen Schicht ist ein Pigmentgemisch, das hohle Mikropartikeln bzw. Mikrokugeln enthält. Besonders bevorzugt werden hohle polymere Mikrokugeln auf Polystyrol/Acrylat-Basis und Styrol- oder Acrylharz-Basis. Der Mikrokugelgehalt im Pigmentgemisch liegt im Bereich 10 bis 80 Gew.%, vorzugsweise jedoch 30 bis 70 Gew.%.

Die hohlen Mikrokugeln weisen einen Durchmesser von 0,4 bis 1 µm auf. Besonders gut geeignet sind Mikrokugeln mit einem Durchmesser von 0,5 bis 1 µm.

Das Pigmentgemisch kann anorganische Pigmente wie TiO₂, CaCO₃, ZnO, ZnS, ZnSO₄, Sb₂O₃, CaSO₄, BaSO₄, Kaolin, Talkum oder Mischungen daraus enthalten. Besonders bevorzugt wird ein Pigmentgemisch aus TiO₂ und hohlen Polystyrol/Acrylat-Mikrokugeln, in dem das Mengenverhältnis TiO₂/Mikrokugeln 3:7 bis 7:3 beträgt.

In einer weiteren Ausführungsform der Erfindung wird ein Pigmentgemisch aus TiO₂, CaCO₃ und hohlen Mikrokugeln eingesetzt, wobei der CaCO₃-Gehalt im Gemisch bis zu 70 Gew.% betragen kann.

Das TiO₂ im Pigmentgemisch liegt im Mengenbereich von 10 bis 80 Gew.%, vorzugsweise von 30 bis 70 Gew.%.

Der Pigmentgesamtgehalt in der Schicht beträgt 5 bis 85 Gew.%, vorzugsweise 50 bis 80 Gew.%.

Die erfindungsgemäße Schicht wird aus wäßriger Dispersion auf den Träger aufgetragen. Dies kann mit allen üblichen Auftragsaggregaten durchgeführt werden. Die Menge der Beschichtungsmasse wird so gewählt, daß nach dem Trocknen ein Auftragsgewicht von 4 bis 20 g/m², vorzugsweise 8 bis 12 g/m² vorliegt.

Die folgenden Beispiele sollen die Erfindung verdeutlichen:

### Beispiel 1 - 6

Ein Basispapier von 180 g/m² Flächengewicht, das auf der Vorderseite mit 30 g/m² Polyethylen (40% HDPE, 60 % LDPE), welches 10 Gew.% Titandioxid enthielt, und auf der Rückseite mit 30g/m² Polyethylen (40% HDPE, 60% LDPE) beschichtet wurde, wurde auf der Vorderseite einer Coronaentladung unterworfen und dann mit den gemäß Tabelle 1 zusammengestellten Schichten versehen. Die Schichten wurden aus wäßriger Dispersion aufgetragen. Im Heißluftkanal wurden die aufgetragenen Schichten zu den in Tabelle 1 aufgeführten Auftragsgewichten getrocknet.

**Tabelle 1**

| Bestandteile | Zusammensetzung, Gew.% | | | | | | |
|---|---|---|---|---|---|---|---|
| | 1 | 2 | 3 | 4 | 5 | 6 | 7 |
| Styrolisiertes Acrylat (Primal® P-376 Lo) | 40 | 50 | 20 | 20 | 20 | - | 20 |
| Vinylchlorid/ Vinylacetat-Cop. (Vinol® 50/25 C) | - | - | - | - | - | 20 | - |
| TiO₂ (RN 40, Fa. Kronos) | 40 | 15 | 24 | 35 | 50 | 35 | 35 |
| CaCO₃ (Hydrocarb® 60) | - | - | 16 | - | - | - | - |
| Hohle Mikrokugeln aus Styrol/Acrylat-Cop., ∅ 0,4 µm (Ropaque® OP 90) | 20 | 35 | 40 | 45 | 30 | 45 | - |
| Hohle Mikrokugeln aus Styrol/Acrylat-Cop., ∅ 1 µm (Ropaque® HP-91) | - | - | - | - | - | _ | 45 |
| Auftragsgewicht, g/m² (trocken) | 8 | 8 | 8 | 12 | 12 | 8 | 12 |

### Vergleichsbeispiele V1 - V4

Ein polyethylenbeschichtetes Basispapier wie in den Beispielen 1 - 6 wurde auf der Vorderseite mit folgenden Schichten versehen:

**Tabelle 2**

| Bestandteile | Zusammensetzung, Gew.% | | | |
|---|---|---|---|---|
| | V1 | V2 | V3 | V4 |
| Styrolisiertes Acrylat (Primal® P-376 Lo, | 20 | 50 | 20 | 20 |
| TiO₂ (RN 40, Fa. Kronos) | 80 | 50 | - | - |
| CaCO₃ (Hydrocarb® 60, | - | - | 80 | - |
| Hohe Mikrokugeln aus Styrol/Acrylat-Cop. (Ropaque® OP 90) | - | - | - | 80 |
| Auftragsgewicht, g/m² (trocken) | 10 | 8 | 8 | 10 |

### Vergleichsbeispiel V5

Ein polyethylenbeschichtetes Basispapier wie in den Beispielen 1 bis 6 wurde direkt als Trägermaterial zur Herstellung von Prüfdrucken herangezogen.

### Herstellung von Prüfdrucken und Ermittlung der Punktzuwächse

Die gemäß den Beispielen und Vergleichsbeispielen hergestellten Trägerpapiere wurden zur Herstellung von Prüfdrucken nach dem Hoechst-Proofverfahren "Pressmatch Dry" und dem Dupont-Proofverfahren "Cromalin" herangezogen. Beide Proofverfahren sind Laminatverfahren.

Bei "Cromalin"-Verfahren wird eine mit UV-empfindlichem Monomer beschichtete Folie auf das Trägerpapier auflaminiert. Das mit der Monomerschicht versehene Material wird in Kontakt mit einem Farbauszugsfilm belichtet. An den vom Licht getroffenen Stellen polymerisiert das Monomer und verliert dabei seine Klebrigkeit. An den verbliebenen klebrigen Stellen lagern sich in einem weiteren Arbeitsschritt Tonerpartikeln an. Diese Vorgehensweise wiederholt sich mit den restlichen Farben.

Beim "Pressmatch Dry"-Verfahren sind die Farbstoffe in lichtempfindlichen Folien eingelagert. Diese werden auf das Trägerpapier nacheinander auflaminiert, belichtet und abgezogen.

Die Belichtung erfolgte unter einem Testelement, dem UGRA-Testkeil 1982 für die Farben Cyan, Magenta, Gelb und Schwarz. Auf dem Testkeil befinden sich Felder, die im 10 % Abstand Flächendeckungen 100 bis 10 % aufweisen.

Die Farbdensitäten wurden in den Testfeldern mit einem Densitometer (Gretag D 186) für die Farbflächendeckung 40 % und 80 % gemessen.

Aus den Densitätswerten wurde dann über die Formel von Murray-Davis der Punktzuwachs berechnet. Diese Werte sind in den Tabellen 3 und 4 zusammengestellt.

Aus den Tabellen ist ersichtlich, daß alle erfindungsgemäßen Trägermaterialien einen niedrigeren optischen Punktzuwachs bewirken. Insbesondere ist dies beim Vergleich mit dem Standardmaterial (V5) zu beobachten.

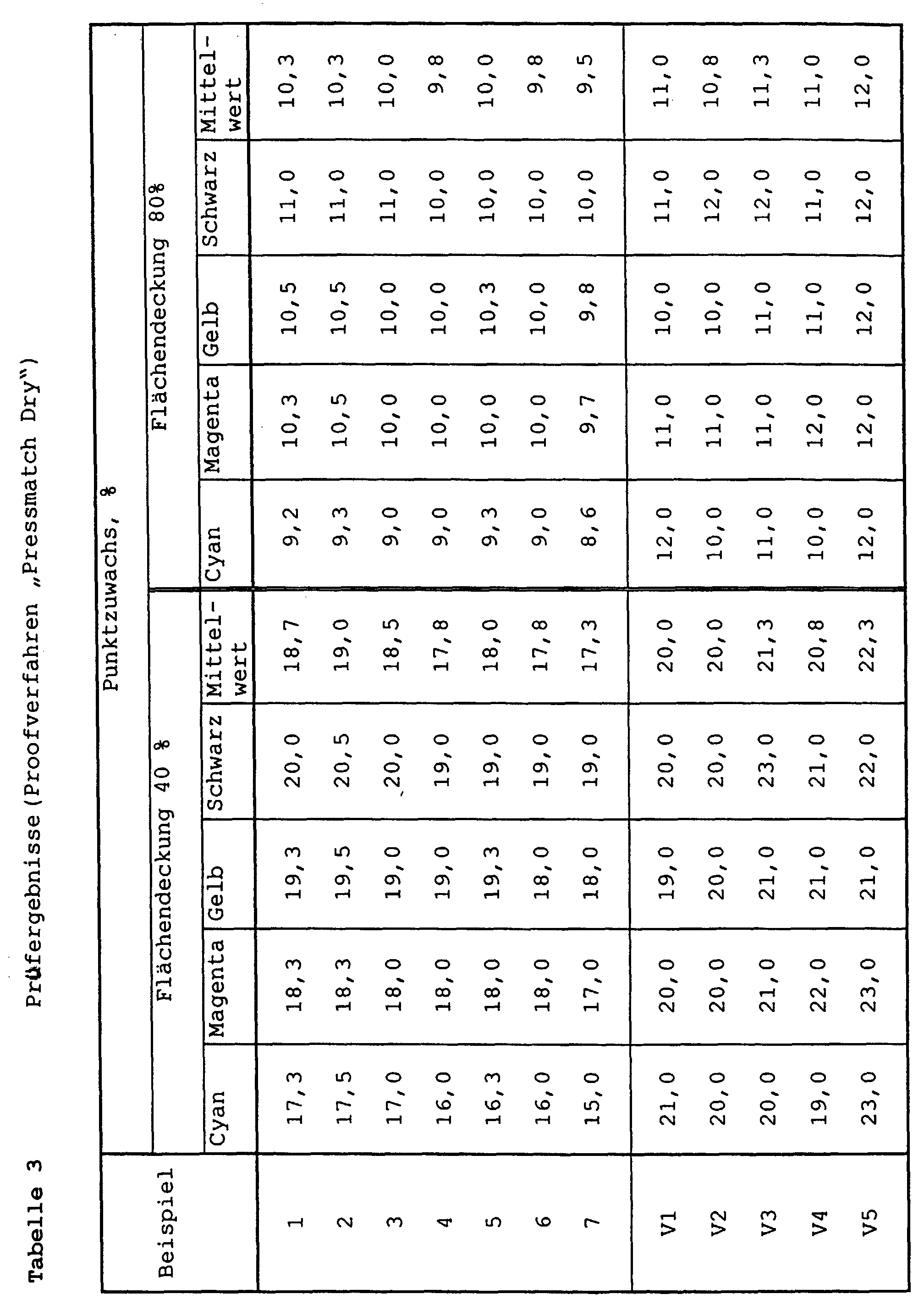

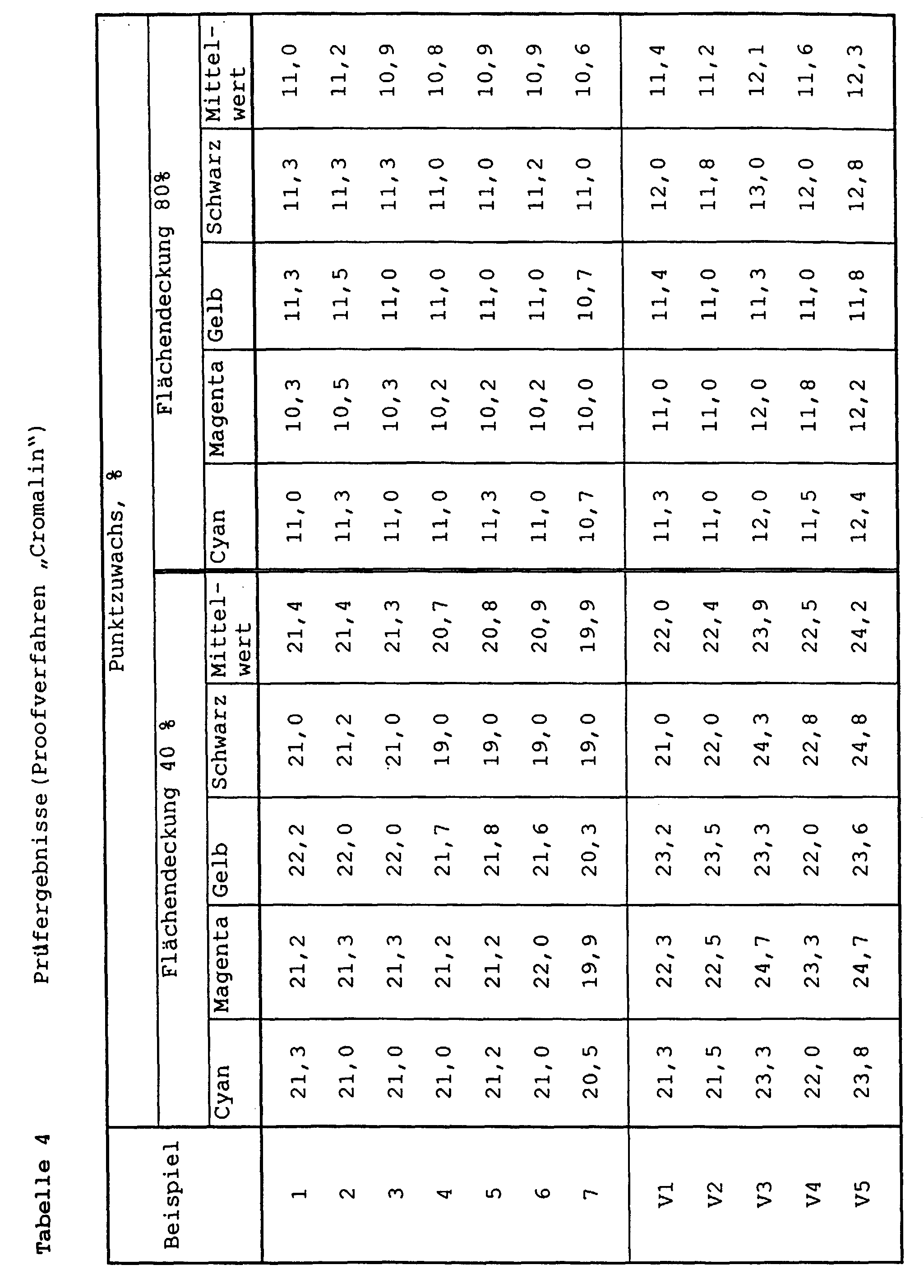

## Patentansprüche

1. Trägermaterial zur Herstellung von Farb-Prüfdrucken im Analog-Proofsystem, enthaltend einen Träger und eine Schicht, **dadurch gekennzeichnet,** daß die Schicht ein hydrophobes Bindemittel oder ein Bindemittelgemisch und ein hohle Mikrokugeln enthaltendes Pigmentgemisch enthält.

2. Trägermaterial nach Anspruch 1, **dadurch gekennzeichnet,** daß das hydrophobe Bindemittel ein Acrylsäureester, Vinylacetat, Vinylchlorid/Vinylacetat-Copolymer, Polystyrol, Polyurethan, Polyvinylchlorid, Polyvinylidenchlorid, Styrol/Butadien-Copolymer und ein styrolisierter Acrylsäureester ist.

3. Trägermaterial nach Anspruch 1 oder 2, **dadurch gekennzeichnet,** daß die hohlen Mikrokugeln polymere Mikrokugeln aus Styrol/Acrylat-Copolymer sind.

4. Trägermaterial nach Anspruch 1 bis 3, **dadurch gekennzeichnet,** daß der Bindemittelgehalt in der Schicht 15 bis 95 Gew.%, vorzugsweise 20 bis 80 Gew.%, ganz besonders bevorzugt 20 bis 50 Gew.%, beträgt.

5. Trägermaterial nach Anspruch 1 bis 4, dadurch gekennzeichnet, daß das hohle Mikrokugeln enthaltende Pigmentgemisch ein Pigment aus der Gruppe TiO₂, CaCO₃, ZnO, ZnS, ZnSO₄, Sb₂O₃, CaSO₄, BaSO₄, Kaolin, Talkum oder eine Mischung daraus enthält.

6. Trägermaterial nach Anspruch 1 bis 5, dadurch gekennzeichnet, daß der TiO2-Gehalt im Pigmentgemisch 10 bis 80 Gew.%, vorzugsweise 30 bis 70 Gew.% beträgt.

7. Trägermaterial nach Anspruch 1 bis 6, dadurch gekennzeichnet, daß der Gehalt an Mikrokugeln im Pigmentgemisch 10 bis 80 Gew.%, vorzugsweise 30 bis 70 Gew.% beträgt.

8. Trägermaterial nach Anspruch 1 bis 7, dadurch gekennzeichnet, daß der Pigmentgehalt in der Schicht 5 bis 85 Gew.%, vorzugsweise 50 bis 80 Gew.% beträgt.

## Claims

1. A support material for making color test prints in the analog proof system, comprising a support and a layer, characterized in that the layer comprises a hydrophobic binder or binder mixture and a pigment mixture containing hollow micro-balls.

2. A support material according to claim 1, characterized in that hydrophobic binder is an acrylic acid ester, vinylacetate, vinylchloride/vinylacetate copolymer, polystyrene, polyurethane, polyvinylchloride, polyvinylidenechloride, styrene/butadiene copolymer and a styrenated acrylic acid ester.

3. A support material according to claim 1 or 2, characterized in that the hollow micro-balls are polymer micro-balls of styrene/acrylate copolymer.

4. A support material according to claims 1 to 3, characterized in that the binder content of the layer amounts to 15 to 95% by weight, preferably 20 to 80% by weight, more preferably 20 to 50% by weight.

5. A support material according to claims 1 to 4, characterized in that the pigment mixture containing hollow micro-balls includes a pigment from the group TiO₂, CaCO₃, ZnO, ZnS, ZnSO4, Sb₂O₃, CaSO₄, BaSO₄, kaolin, talcum or a mixture thereof.

6. A support material according to claims 1 to 5, characterized in that the TiO₂ content in the pigment mixture amounts to 10 to 80% by weight, preferably 30 to 70% by weight.

7. A support material according to claims 1 to 6, characterized in that the content of the micro-balls in the pigment mixture amounts to 10 to 80% by weight, preferably 30 to 70% by weight.

8. A support material according to claims 1 to 7, characterized in that the pigment content of the layer amounts to 5 to 85% by weight, preferably 50 to 80% by weight.

## Revendications

1. Matériau de support pour la préparation d'épreuves en couleur dans le système d'essai analogique contenant un support et une couche, caractérisé en ce que la couche contient un liant hydrophobe ou un mélange de liants et un mélange de pigments comportant des microbilles creuses.

2. Matériau de support selon la revendication 1, caractérisé en ce que le liant hydrophobe est un ester de l'acide acrylique, de l'acétate de vinyle, un copolymère de chlorure de vinyle et d'acétate de vinyle, un polystyrène, un polyuréthane, un polychlorure de vinyle, un polychlorure de vinylidène, un copolymère de styrène et de butadiène ou un ester styrénisé de l'acide acrylique.

3. Matériau de support selon la revendication 1 ou 2, caractérisé en ce que les microbilles creuses sont des microbilles polymères formées d'un copolymère de styrène et d'acrylate.

4. Matériau de support selon les revendications 1 à 3, caractérisé en ce que la teneur en liant dans la couche est comprise entre 15 et 95% en poids et, de préférence, entre 20 et 80% en poids et, plus particulièrement encore, entre 20 et 50% en poids.

5. Matériau de support selon les revendications 1 à 4, caractérisé en ce que le mélange de pigments contenant les microbilles creuses contient un pigment choisi dans le groupe formé de TiO₂, CaCO₃, ZnO, ZnS, ZnSO₄, Sb₂O₃, CaSO₄, BaSO₄, de kaolin, de talc ou d'un mélange de ceux-ci.

6. Matériau de support selon les revendications 1 à 5, caractérisé en ce que la teneur en TiO₂ dans le mélange de pigments est comprise entre 10 et 80% en poids et, de préférence, entre 30 et 70% en poids.

7. Matériau de support selon les revendications 1 à 6, caractérisé en ce que la teneur en microbilles dans le mélange de pigments est comprise entre 10 et 80% en poids et, de préférence entre 30 et 70% en poids.

8. Matériau de support selon les revendications 1 à 7, caractérisé en ce que la teneur en pigment dans la couche est comprise entre 5 et 85% en poids et, de préférence, entre 50 et 80% en poids.
